# EUROPÄISCHE PATENTSCHRIFT

(11) **EP 4 406 104 B1**
(45) Veröffentlichungstag und Bekanntmachung des Hinweises auf die Patenterteilung: **04.02.2026**
(21) Anmeldenummer: 22777237.3
(22) Anmeldetag: 19.09.2022
(51) Int. Cl.: H02K 9/19, H02K 44/00, H05B 6/50, H05B 6/62, F04B 19/00, F04B 23/04, F04B 53/08

(54) **TEMPERIERANORDNUNG FÜR EIN MIKROELEKTRISCHES SYSTEM**
TEMPERATURE-CONTROL ASSEMBLY FOR A MICROELECTRIC SYSTEM
ENSEMBLE DE RÉGULATION DE TEMPÉRATURE POUR UN SYSTÈME MICROÉLECTRIQUE

(30) Priorität: 23.09.2021 DE 102021210606
(43) Veröffentlichungstag der Anmeldung: 31.07.2024
(73) Patentinhaber: Robert Bosch GmbH, 70442 Stuttgart (DE)
(72) Erfinder: KOCOUREK, Vaclav, 71717 Beilstein (DE); KETTERER, Markus, 70563 Stuttgart (DE); ASTNER, Martin, 74385 Pleidelsheim (DE); KLEIN, Rico Alf, 74081 Heilbronn (DE); SCHULZ, Udo, 71665 Vaihingen/Enz (DE); STRAUB, Hubert, 72076 Tuebingen (DE)
(86) Internationale Anmeldenummer: PCT/EP2022/075954
(87) Internationale Veröffentlichungsnummer: WO 2023/046629

(56) Entgegenhaltungen:
- DE-A1- 102017 214 173
- US-A1- 2006 045 755
- US-A1- 2011 037 325
- US-A1- 2021 257 278
- US-B1- 6 658 861

## Beschreibung

Die Erfindung betrifft eine Temperieranordnung für ein mikroelektrisches System. Gegenstand der vorliegenden Erfindung ist auch ein mikroelektrisches System mit einer solchen Temperieranordnung.

Die Magnetohydrodynamik (MHD) ist ein Teilgebiet der Physik. Sie beschreibt das Verhalten elektrisch leitender Fluide, die von magnetischen und elektrischen Feldern durchdrungen werden. Die Magnetohydrodynamik im engeren Sinne behandelt Flüssigkeiten, insbesondere auch Plasmen, welche im Rahmen der MHD als Fluide beschrieben werden. Typische Anwendungsgebiete der Magnetohydrodynamik sind die Strömungsbeeinflussung und die Strömungsmessung in Metallurgie und Halbleitereinkristallzüchtung. So können in der Metallurgie beispielsweise Magnetfelder eingesetzt werden, um die Strömung von Flüssigmetallen, wie beispielsweise Stahl oder Aluminium zu beeinflussen. Bei der Anwendung ist zwischen statischen und zeitabhängigen Magnetfeldern zu unterscheiden. Statische, d.h. zeitunabhängige, Magnetfelder führen zu einer Dämpfung von Turbulenz und werden deshalb beispielsweise in Form magnetischer Bremsen beim Stranggießen von Stahl eingesetzt. Zeitabhängige Magnetfelder finden beispielsweise Anwendung zum elektromagnetischen Abstützen beim Gießen von Aluminium.

Aus der DE 10 2017 214 173 A1 ist eine hydraulische Aktorvorrichtung für ein mit einem elektrisch leitfähigen Medium gefülltes hydraulisches System bekannt. Die hydraulische Aktorvorrichtung ist an und/oder in dem hydraulischen System anordenbar oder angeordnet, und umfasst mindestens ein Aktormodul, welches jeweils so ausgebildet ist, dass zumindest eine Teilmenge des elektrisch leitfähigen Mediums aufgrund seiner Wechselwirkung mit einem mittels des jeweiligen Aktormoduls erzeugten elektrischen Stromfluss und/oder mit einem mittels des jeweiligen Aktormoduls bewirkten magnetischen Feld in zumindest ein Teilvolumen des hydraulischen Systems beschleunigbar ist, wodurch ein Druckaufbau in dem zumindest einen Teilvolumen des hydraulischen Systems bewirkbar ist. Zudem werden eine Temperiervorrichtung, eine Sensorvorrichtung und ein hydraulisches System mit einer solchen hydraulische Aktorvorrichtung offenbart. Des Weiteren werden ein Verfahren zum Bewirken eines Druckaufbaus in zumindest einem Teilvolumen eines mit einem elektrisch-leitfähigen Medium gefüllten hydraulischen Systems, ein Verfahren zum Temperieren eines elektrisch leitfähigen Mediums in einem hydraulischen System und ein Verfahren zum Ermitteln einer Information bezüglich einer Fließgeschwindigkeit eines elektrisch leitfähigen Mediums in einem hydraulischen System offenbart. Die Temperiervorrichtung umfasst mindestens eine Elektrode, über welche ein Heizstrom in das elektrisch-leitfähige Medium des hydraulischen Systems einleitbar ist, wodurch Wärme in dem elektrisch-leitfähigen Medium erzeugt und dessen Erstarren verhindert werden kann.

Aus der US 6,658,861 B1 ist ein Kühlsystem für ein Hochleistungssystem bekannt, welches einem Gerät mit hoher Leistungsdichte Wärme entzieht und diese Wärme an einer beabstandeten Position über einen Kühlkörper ableitet. In dem Kühlsystem zirkuliert flüssiges Metall in einer geschlossenen Leitung und nutzt dabei eine oder mehrere elektromagnetische Pumpen, um die Wärme von dem Gerät mit hoher Leistungsdichte abzuleiten und an den entfernt angeordneten Kühlkörper abzugeben. Das System kann einen thermoelektrischen Generator nutzen, um die elektromagnetischen Pumpen anzutreiben, indem es den Temperaturunterschied zwischen den Einlass- und Auslassrohren des Kühlkörpers nutzt. Das System bietet außerdem Netzwerke primärer und sekundärer geschlossener Leitungen mit Reihen- und Parallelanordnung elektromagnetischer Pumpen zur Wärmeableitung mehrerer Geräte an einen entfernt gelegenen Kühlkörper. Eine solche elektromagnetische Pumpen besteht aus einem Paar Elektrodenplatten, die vertikal einander gegenüberliegende angeordnet sind. An die Elektrodenplatten wird eine Gleichspannung angelegt. Die Gleichspannung erzeugt ein elektrisches Feld über den Elektrodenplatten. Ein Paar Permanentmagnete ist einander zugewandt oberhalb und unterhalb der Ebene angeordnet, welch die Elektrodenplatten enthält. Ein Rohr führt flüssiges Metall. Die Richtung des von den Permanentmagneten erzeugten Magnetfelds verläuft senkrecht zur Richtung des von den Elektrodenplatten bereitgestellten elektrischen Felds. Auf das flüssige Metall wirkt eine elektromagnetische Kraft, die dazu führt, dass es in einer Richtung senkrecht zur Ebene der elektrischen und magnetischen Felder fließt.

### Offenbarung der Erfindung

Die Temperieranordnung für ein mikroelektrisches System mit den Merkmalen des unabhängigen Patentanspruchs 1 und das mikroelektrische System mit den Merkmalen des unabhängigen Patentanspruchs 12 haben jeweils den Vorteil, dass ein skalierbares Temperieren (Kühlen oder Heizen) für zu temperierende Objekte von mikroelektronischen Systemen ermöglicht wird, ohne die zu temperierenden Objekte durch ungewollte elektrische oder elektromagnetische Effekte zu stören.

Kern der Erfindung ist eine magnetohydrodynamische Pumpe mit zwei Pumpmodulen, welche zur Förderung von geeigneten elektrisch und thermisch leitenden Medien zum Temperieren, d.h. zum Kühlen bzw. Heizen der zu temperierenden Objekte, wie beispielsweise Elektronikbauteile, Halbleiterbauelemente, Steuergeräte usw., elektrisch in Reihe geschaltet sind. Durch die elektrische Reihenschaltung von mehreren Pumpmodulen kann der erforderliche elektrische Strom gegenüber nur einem Pumpmodul bei gleicher Spannung entsprechend der Anzahl von elektrisch in Reihe geschalteten Pumpmodulen deutlich reduziert werden. Dadurch können die elektrischen und elektromagnetischen Störungen der zu temperierenden Objekte verringert und die Pumpmodule kleiner ausgeführt werden. Gegenüber bekannten Systemen mit einem Pumpmodul reduziert die Reihenschaltung von mindestens zwei Pumpmodulen auch die elektrischen Verluste im elektrisch und thermisch leitfähigen Medium und in einer elektrischen Zuleitung der magnetohydrodynamischen Pumpe, wodurch auch die Effizienz steigt. Zudem können je nach Struktur eines zugehörigen geschlossenen Kanalsystems korrespondierende Kanäle des Kanalsystems oder Bereiche des zu temperierenden Objekts auch individuell nach Bedarf temperiert werden, wodurch eine gleichmäßige Kühlung bzw. Aufheizung und eine gleichmäßige Temperaturverteilung am temperierenden Objekt realisiert werden können. Dadurch entstehen weniger mechanische Spannungen und Wärmeströme. Da die einzelnen Pumpmodule sehr klein ausgeführt werden können, können beliebige Kanalstrukturen beispielsweise bis auf Siliziumeben individuell mittels zugehöriger Pumpmodule bezüglich der Temperatur in dem mindestens einen Kanal geregelt werden, so dass korrespondierende Halbleiterstrukturen optimal temperiert werden können. Auch die Temperierung bzw. Kühlung von anderen elektronischen Bauelementen, wie beispielsweise Elektrolytkondensatoren können mit Ausführungsformen der erfindungsgemäßen Temperieranordnung optimal gekühlt werden. Dadurch können die Lebensdauer der Elektrolytkondensatoren deutlich verbessert und so Kapazitätsvorhalte und damit Bauraum und Schüttelfestigkeitsprobleme in dem korrespondierenden mikroelektrischen System verringert werden.

Ausführungsformen der vorliegenden Erfindung stellen eine Temperieranordnung für ein mikroelektrisches System, mit einem geschlossenem Kanalsystem, welches mindestens einen Kanal zur Führung eines elektrisch und thermisch leitfähigen Mediums umfasst und thermisch mit mindestens einem zu temperierenden Objekt des mikroelektrischen Systems gekoppelt ist, und einer magnetohydrodynamischen Pumpe mit mehreren magnetohydrodynamischen Modulen zur Verfügung, welche jeweils eine Elektrodenvorrichtung mit zwei Elektroden und eine Magnetvorrichtung aufweisen, welche ein magnetisches Feld erzeugt. Hierbei sind mindestens zwei magnetohydrodynamische Module als Pumpmodule ausgeführt und elektrisch in Reihe geschaltet. In den Pumpmodulen leitet jeweils eine erste Elektrode der Elektrodenvorrichtung einen elektrischen Stromfluss mit einer vorgegebenen Stromdichte an mindestens einem Kanalabschnitt in das elektrisch und thermisch leitfähige Medium ein und eine zweite Elektrode der Elektrodenvorrichtung leitet den elektrischen Stromfluss an dem mindestens einen Kanalabschnitt aus dem elektrisch und thermisch leitfähigen Medium aus, so dass ein Zusammenwirken des in dem geschlossenen Kanalsystem geführten elektrisch und thermisch leitfähigen Mediums mit dem eingeleiteten elektrischen Stromfluss und mit dem erzeugten magnetischen Feld eine Lorenzkraft erzeugt, welche das elektrisch und thermisch leitfähige Medium in dem mindestens einen Kanalabschnitt gezielt beschleunigt, und ein resultierender Druckaufbau einen gewünschten Volumenstrom des elektrisch und thermisch leitfähigen Mediums durch den mindestens einen Kanal des geschlossenen Kanalsystems bewirkt.

Der Volumenstrom des elektrisch und thermisch leitfähigen Mediums bewirkt eine Temperierung des mindestens einen zu temperierenden Objekts, wobei das elektrisch und thermisch leitfähige Medium während eines Heizvorgangs Wärme an das mindestens eine zu temperierende Objekt überträgt oder während eines Kühlvorgangs Wärme von dem mindestens einen zu temperierenden Objekt aufnimmt.

Die mindestens zwei Pumpmodule sind in einem gemeinsamen Kanal fluidisch in Reihe hintereinander angeordnet. Ein solche elektrische und fluidische Reihenschaltung steigert den elektrischen Wirkungsgrad und verringert EMV-Probleme. Hierbei erzeugt die eine Reihenschaltung der mindestens zwei Pumpmodule einen mit jedem Pumpmodul größer werdenden Druck in dem elektrisch und thermisch leitfähigen Medium des korrespondierenden Kanals, welcher den Volumenstrom durch den mindestens einen Kanal des geschlossenen Kanalsystems antreibt. Die mindestens zwei fluidisch in Reihe angeordneten Pumpmodule können beispielsweise hintereinander vor oder nach dem mindestens einen zu temperierenden Objekt angeordnet sein. Durch die benachbarte Anordnung der mindestens zwei Pumpmodule kann ein Teilstrom durch das elektrisch und thermisch leitfähige Medium fließen. Dieser Teilstrom kann bei Temperaturen unterhalb der tiefsten spezifizierten Temperatur zum Heizen des elektrisch und thermisch leitfähigen Mediums im Kanalsystem verwendet werden. Erfindungsgemäß sind die mindestens zwei fluidisch in Reihe angeordneten Pumpmodule getrennt voneinander angeordnet. Hierbei ist mindestens ein erstes Pumpmodul vor und mindestens ein zweites Pumpmodul nach dem mindestens einen zu temperierenden Objekt angeordnet. Durch diese Anordnung kann das mindestens eine erste Pumpmodul vor dem temperierenden Objekt nur so ausgeführt werden, dass der Druck ausreicht, um einen ausreichenden Volumenstrom durch das Kanalsystem im Bereich des zu temperierenden Objekts zu treiben. Das mindestens eine zweite Pumpmodul nach dem zu temperierenden Objekt kann dann so ausgeführt werden, dass es einen ausreichenden Volumenstrom durch das restliche Kanalsystem treiben kann. Eingeschränkt kann das mindestens eine zweite Pumpmodul auch saugen. Vorteilhaft ist bei dieser Anordnung, dass keine unnötige Druckbelastung des geschlossenen Kanalsystems im Bereich des zu temperierenden Objekts und damit auch kein mechanischer Stress des zu temperierenden Objekts erfolgt. Dies ermöglicht eine dünnere Ausführung der Wände des geschlossenen Kanalsystems. Denkbar ist auch eine Pendelkühlung, das bedeutet, dass das elektrisch und thermisch leitfähige Mediums durch eine Stromrichtungsumkehr in der magnetohydrodynamischen Pumpe mal in die eine Richtung und mal in die andere Richtung bewegt werden kann.

Zudem wird ein mikroelektrisches System mit mindestens einem zu temperierenden Objekt und mindestens einer solchen Temperieranordnung zur Temperierung des mindestens einen zu temperierenden Objekts vorgeschlagen.

Ausführungsformen der erfindungsgemäßen Temperieranordnung ermöglichen beispielsweise durch eine individuelle und/oder dynamische und/oder stufenlose und/oder gezielte und/oder gleichmäßige Kühlung einzelner zu kühlender elektronischer bzw. elektrischer Bauelemente des mikroelektrisches Systems, im Vergleich zum Stand der Technik, deutliche leistungsfähigere und effizientere mikroelektrische Systeme. Falls erforderlich ist zusätzlich auch eine individuelle und/oder dynamische und/oder stufenlose und/oder gezielte und/oder gleichmäßige Erwärmung der einzelnen elektronischen bzw. elektrischen Bauelemente des mikroelektrisches Systems möglich.

Zudem ermöglicht der Einsatz von mehreren Pumpmodulen in der magnetohydrodynamischen Pumpe eine kleinere bauliche Ausführung der einzelnen Pumpmodule. Durch diese kompakte Bauform der einzelnen Pumpmodule und durch den Einsatz von mehreren Pumpmodulen kann der vorhandene Bauraum variabel und besser genutzt werden, als bei der Verwendung von nur einem großen Pumpmodul. Des Weiteren ergibt sich durch Nichtvorhandensein mechanisch bewegter Teile ein geringer mechanischer Verschleiß und ein gutes Geräuschverhalten der magnetohydrodynamischen Pumpe.

Unter einem dem elektrisch und thermisch leitfähigen Medium wird nachfolgend ein Medium mit einer elektrischen Leitfähigkeit verstanden, welcher größer als 1 S/m (Siemens pro Meter) ist. Vorzugsweise hat das elektrisch und thermisch leitfähige Medium eine deutlich größere elektrische Leitfähigkeit (100 bis 1000 S/m). Als elektrisch und thermisch leitfähiges Medium kann beispielsweise eine elektrisch und thermisch leitfähige Flüssigkeit, ein elektrisch und thermisch leitfähiges Gas, eine ionische Flüssigkeit, mindestens ein Elektrolyt, mindestens ein Plasma, mindestens ein Flüssigmetall, wie beispielsweise Gallium, Lithium, Natrium oder Quecksilber, und/oder mindestens eine Flüssigmetalllegierung, wie beispielsweise eine Natrium-Kalium-Legierung, verwendet werden. Vorzugsweise kann eine ungiftige flüssige Metalllegierung aus Gallium, Indium und Zinn als elektrisch und thermisch leitfähiges Medium verwendet werden. Diese ist bei Atmosphärendruck bereits ab einer Temperatur von -20°C flüssig und kann einfach von einer tieferen Temperatur auf eine Temperatur von -20°C oder höher aufgeheizt werden. Die hier beschriebenen Beispiele für das elektrisch und thermisch leitfähige Medium sind jedoch nicht abschließend zu werten.

Durch die in den abhängigen Ansprüchen aufgeführten Maßnahmen und Weiterbildungen sind vorteilhafte Verbesserungen der im unabhängigen Patentanspruch 1 angegebenen Temperieranordnung für ein mikroelektrisches System und des im unabhängigen Patentanspruch 12 angegebenen mikroelektrischen Systems möglich.

Besonders vorteilhaft ist, dass das geschlossene Kanalsystem thermisch mit mindestens einem Wärmeübertrager gekoppelt sein kann, welcher für den Heizvorgang als Heizelement oder für den Kühlvorgang als Kühlelement ausgeführt sein kann. Das bedeutet, dass der mit dem Kanalsystem thermisch gekoppelte Wärmeübertrager bei einem Heizvorgang dem elektrisch und thermisch leitfähigen Medium Wärme zuführt und bei einem Kühlvorgang Wärme aus dem elektrisch und thermisch leitfähigen Medium aufnimmt.

In weiterer vorteilhafter Ausgestaltung der Temperieranordnung kann das geschlossene Kanalsystem zumindest teilweise in einem thermisch leitenden Grundkörper angeordnet sein, welcher thermisch mit dem mindestens einen zu temperierenden Objekt gekoppelt ist. Das bedeutet, dass der Grundkörper bei einem Kühlbetrieb als Kühlelement wirken kann, welches Wärme von dem zu temperierenden Objekt in das elektrisch und thermisch leitfähige Medium überträgt, und bei einem Heizvorgang als Heizelement wirken kann, welches dem elektrisch und thermisch leitfähigen Medium Wärme entzieht und an das zu temperierende Objekt überträgt. Zudem kann der Grundkörper das geschlossene Kanalsystem und die magnetohydrodynamische Pumpe vollständig aufnehmen. Dies ermöglicht eine besonders kompakte Ausführungsform der Temperieranordnung. Hierbei kann der Grundkörper beispielsweise direkt oder über ein thermisch leitfähiges Schnittstellenmaterial mit einer Oberseite oder einer Unterseite des mindestens einen zu temperierenden Objekts thermisch gekoppelt sein. Alternativ kann zwischen dem Grundkörper und dem zu temperierenden Objekt eine Platine oder ein Schaltungsträger angeordnet sein, so dass der Grundkörper über mindestens eine thermisch leitfähige Durchkontaktierung mit einer Oberseite oder einer Unterseite des mindestens einen zu temperierenden Objekts thermisch gekoppelt sein kann.

In weiterer vorteilhafter Ausgestaltung der Temperieranordnung kann der mindestens eine Kanal zumindest innerhalb des Grundkörpers von einer elektrischen Isolierung umgeben sein. Dadurch kann ein ungewollter Kurzschluss zwischen dem elektrisch und thermisch leitfähigen Medium und dem Grundkörper verhindert werden, da bei einer elektrischen Reihenschaltung der Pumpmodule der magnetohydrodynamischen Pumpe ein Teilstrom durch das elektrisch und thermisch leitfähige Medium fließen kann.

In weiterer vorteilhafter Ausgestaltung der Temperieranordnung kann mindestens ein magnetohydrodynamisches Modul als Sensormodul ausgeführt sein, bei welchem die Elektroden der Elektrodenvorrichtung an dem mindestens einen Kanalabschnitt eine durch den Volumenstrom des elektrisch und thermisch leitfähigen Mediums in Zusammenwirkung mit dem erzeugten magnetischen Feld der Magnetvorrichtung resultierende Induktionsspannung abgreifen können, aus welcher eine Strömungsgeschwindigkeit des elektrisch und thermisch leitfähigen Mediums ermittelt werden kann. Da die induzierte Spannung proportional zum Durchfluss ist, ist auch eine Regelung des Durchflusses möglich, um das zu temperierende Objekt optimal kühlen oder aufheizen zu können. Durch Messung der Temperatur des elektrisch und thermisch leitfähigen Mediums unter Ausnutzung der Temperaturabhängigkeit der elektrischen Leitfähigkeit des elektrisch und thermisch leitfähigen Mediums ist eine dynamische und gezielte Temperaturregelung möglich. Hierbei kann zur Temperaturmessung die magnetohydrodynamische Pumpe kurzzeitig abgeschaltet werden, um die Leitfähigkeit des elektrisch und thermisch leitfähigen Mediums beispielsweise über eine Messbrücke zu ermitteln. Hierbei kann zusätzlich zu den mindestens zwei Pumpmodulen ein magnetohydrodynamisches Modul als Sensormodul eingesetzt werden. Alternativ kann mindestens ein magnetohydrodynamisches Modul umschaltbar ausgeführt sein und in einer ersten Betriebsart als Pumpmodul und in einer zweiten Betriebsart als Sensormodul betrieben werden. Hierbei kann die erste Betriebsart einem Pumpbetrieb und die zweite Betriebsart einem Messbetrieb entsprechen. Dadurch kann ein magnetohydrodynamisches Modul eingespart werden. Über die Messung der Strömungsgeschwindigkeit kann dabei festgestellt werden, ob die magnetohydrodynamische Pumpe abgeschaltet ist und sich das elektrisch und thermisch leitfähige Medium nicht mehr bewegt. Statt der Leitfähigkeitsmessung können auch explizite Temperatursensoren an Einlässen oder Auslässen der Kanäle oder verteilt auf der Fläche des Grundkörpers genutzt werden, um die Pumpmodule individuell bzw. bedarfsgerecht ansteuern zu können. Weiterführend können auch Temperatursensoren in dem zu temperierenden Objekt genutzt werden. Durch die Messung der Strömungsgeschwindigkeit und/oder der Temperatur des elektrisch und thermisch leitfähigen Mediums ergibt sich eine gute Regelbarkeit von einzelnen Kanälen durch ein direktes Wirkprinzip. Zudem ist ein effizientes Pumpen des elektrisch und thermisch leitfähigen Mediums durch die Kanalstrukturen des geschlossenen Kanalsystems möglich.

In weiterer vorteilhafter Ausgestaltung der Temperieranordnung können die mindestens zwei Pumpmodule fluidisch parallel in mindestens zwei parallel verlaufenden Kanälen angeordnet sein. Dies ermöglicht eine gezielte Ansteuerung von einzelnen Kanälen des geschlossenen Kanalsystems. Hierbei können in mindestens einem der mindestens zwei parallel verlaufenden Kanäle mindestens zwei fluidisch in Reihe hintereinander angeordnete magnetohydrodynamische Module angeordnet sein. Durch diese fluidische Parallelschaltung der mindestens zwei Pumpmodule kann der gesamte Volumenstrom in dem geschlossenen Kanalsystem erhöht werden, ohne den Druck weiter zu erhöhen. In Verbindung mit der oben beschriebenen Temperaturmessung kann eine individuelle Volumenströmung in den einzelnen parallel verlaufenden Kanälen realisiert werden, um beispielsweise Hotspots auf dem zu temperierenden Objekt zu vermeiden bzw. ganz gezielt verlustreiche Bereiche des zu temperierenden Objekts zu kühlen oder für eine gleichmäßige Temperatur oder eine gezielte Temperaturverteilung zu sorgen. Denkbar wäre auch eine räumlich höhere Auflösung der Temperaturerfassung durch lokale Temperaturmessungen, beispielsweise durch jeweils zwei aufeinanderfolgende Elektroden auf einer Seite des jeweiligen Kanalabschnitts, welche entweder in den Pumpmodulen integriert oder separat entlang des Kanalabschnitts angebracht sein können. Des Weiteren kann die Temperatur auch durch zwei gegenüberliegende Elektroden eines Elektrodenpaares erfasst werden. Um einen denkbaren Einfluss des bewegten elektrisch und thermisch leitfähigen Mediums auf die Messung zu vermeiden kann es sinnvoll sein, die Pumpmodule für den Messzeitpunkt anzuhalten.

In weiterer vorteilhafter Ausgestaltung der Temperieranordnung kann die mindestens eine Magnetvorrichtung mindestens zwei Permanentmagnete oder mindestes eine elektrische Spulenvorrichtung umfassen. Durch die Verwendung von mindestens zwei Permanentmagnete kann einfach ein statisches Magnetfeld zur Verfügung gestellt werden. Durch die mindestens eine Spulenvorrichtung kann ein zeitlich variierendes Magnetfeld zur Verfügung gestellt werden.

In vorteilhafter Ausgestaltung des mikroelektrischen Systems können die mindestens eine Temperieranordnung und das mindestens eine zu temperierende Objekt von einer gemeinsamen Umhüllung umgeben sein. Dies ermöglicht eine besonders kompakte Bauform.

Ausführungsbeispiele der Erfindung sind in den Zeichnungen dargestellt und werden in der nachfolgenden Beschreibung näher erläutert. In den Zeichnungen bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Darstellung eines ersten Ausführungsbeispiels einer erfindungsgemäßen Temperieranordnung für ein mikroelektrisches System.
Fig. 2 zeigt eine schematische Darstellung eines Ausführungsbeispiels einer magnetohydrodynamischen Pumpe 7 der erfindungsgemäßen Temperieranordnung aus Fig. 1.
Fig. 3 zeigt eine schematische Schnittdarstellung entlang der Schnittlinie III - III in Fig. 2.
Fig. 4 zeigt eine schematische Darstellung eines ersten Ausführungsbeispiels eines mikroelektrischen Systems mit der erfindungsgemäßen Temperieranordnung aus Fig. 1 bis 3.
Fig. 5 zeigt eine schematische Darstellung eines zweiten Ausführungsbeispiels eines mikroelektrischen Systems mit der erfindungsgemäßen Temperieranordnung aus Fig. 1 bis 3.
Fig. 6 zeigt eine schematische Darstellung eines dritten Ausführungsbeispiels eines mikroelektrischen Systems mit der erfindungsgemäßen Temperieranordnung aus Fig. 1 bis 3.
Fig. 7 zeigt eine schematische Darstellung eines zweiten Ausführungsbeispiels einer Temperieranordnung für ein mikroelektrisches System.
Fig. 8 zeigt eine schematische Darstellung eines dritten Ausführungsbeispiels einer erfindungsgemäßen Temperieranordnung für ein mikroelektrisches System.
Fig. 9 zeigt eine schematische Darstellung eines vierten Ausführungsbeispiels einer erfindungsgemäßen Temperieranordnung für ein mikroelektrisches System.

### Ausführungsformen der Erfindung

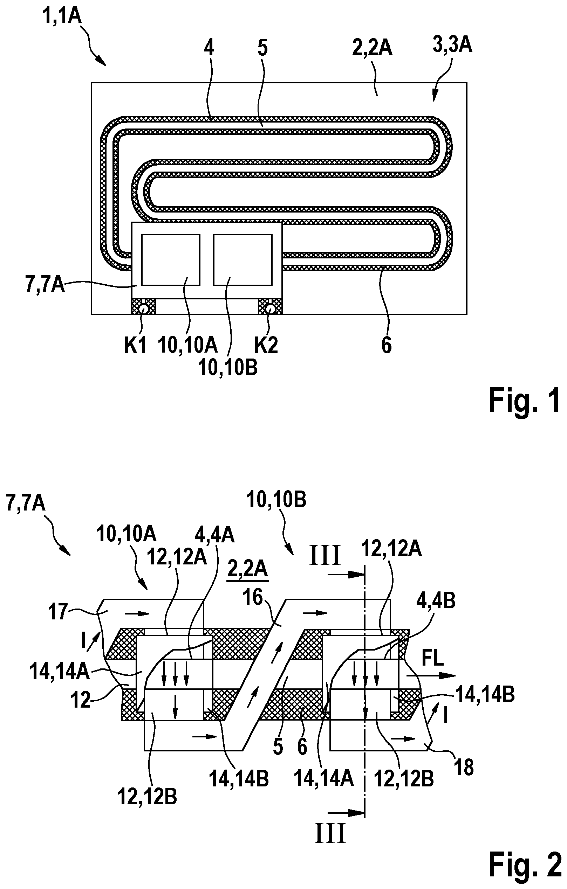

Wie aus Fig. 1 bis 9 ersichtlich ist, umfassen die dargestellten Ausführungsbeispiele einer erfindungsgemäßen Temperieranordnung 1, 1A, 1B, 1C, 1D für ein mikroelektrisches System 20, 20A, 20B, 20C, 20D jeweils ein geschlossenes Kanalsystem 3, 3A, 3B, 3C, 3D, welches mindestens einen Kanal 4 zur Führung eines elektrisch und thermisch leitfähigen Mediums 5 umfasst und thermisch mit mindestens einem zu temperierenden Objekt 9 des mikroelektrischen System 20, 20A, 20B, 20C, 20D gekoppelt ist, und einer magnetohydrodynamischen Pumpe 7, 7A, 7B, 7C mit mehreren magnetohydrodynamischen Modulen 10, welche jeweils eine Elektrodenvorrichtung 12 mit zwei Elektroden 12A, 12B und eine Magnetvorrichtung 14 aufweisen, welche ein magnetisches Feld B erzeugt. Hierbei sind mindestens zwei magnetohydrodynamische Module 10 als Pumpmodule 10A, 10B ausgeführt und elektrisch in Reihe geschaltet. In den Pumpmodulen 10A, 10B leitet jeweils eine erste Elektrode 12A der Elektrodenvorrichtung 12 einen elektrischen Stromfluss I mit einer vorgegebenen Stromdichte j an mindestens einem Kanalabschnitt 4A, 4B in das elektrisch und thermisch leitfähige Medium 5 ein, und eine zweite Elektrode 12B der Elektrodenvorrichtung 12 leitet den elektrischen Stromfluss I an dem mindestens einen Kanalabschnitt 4A, 4B aus dem elektrisch und thermisch leitfähigen Medium 5 aus, so dass ein Zusammenwirken des in dem geschlossenen Kanalsystem 3, 3A, 3B, 3C, 3D geführten elektrisch und thermisch leitfähigen Mediums 5 mit dem eingeleiteten elektrischen Stromfluss I und mit dem erzeugten magnetischen Feld B eine Lorenzkraft FL erzeugt, welche das elektrisch und thermisch leitfähige Medium 5 in dem mindestens einen Kanalabschnitt 4A, 4B gezielt beschleunigt, und ein resultierender Druckaufbau einen gewünschten Volumenstrom des elektrisch und thermisch leitfähigen Mediums 5 durch den mindestens einen Kanal 4 des geschlossenen Kanalsystems 3, 3A, 3B, 3C, 3D bewirkt. Der Volumenstrom des elektrisch und thermisch leitfähigen Mediums 5 bewirkt eine Temperierung des mindestens einen zu temperierenden Objekts 9, wobei das elektrisch und thermisch leitfähige Medium 5 während eines Heizvorgangs Wärme an das mindestens eine zu temperierende Objekt 9 überträgt oder während eines Kühlvorgangs Wärme von dem mindestens einen zu temperierenden Objekt 9 aufnimmt.

Wie aus Fig. 1 und 2 weiter ersichtlich ist, umfasst das dargestellte erste Ausführungsbeispiel der magnetohydrodynamischen Pumpe 7A zwei elektrisch und fluidisch in Reihe geschaltete Pumpmodule 10A, 10B. Hierbei ist ein erster elektrischer Kontakt K1 der magnetohydrodynamische Pumpe 7A über eine ersten Anschlussleitung 17 elektrisch mit der ersten Elektrode 12A einer ersten Elektrodenvorrichtung 12 eines ersten Pumpmoduls 10A verbunden. Die zweite Elektrode 12B der ersten Elektrodenvorrichtung 12 des ersten Pumpmoduls 10A ist über eine Verbindungsleitung 16 mit der ersten Elektrode 12A einer zweiten Elektrodenvorrichtung 12 eines zweiten Pumpmoduls 10B verbunden. Die zweite Elektrode 12B der zweiten Elektrodenvorrichtung 12 des zweiten Pumpmoduls 10B ist über eine zweite Anschlussleitung 18 mit einem zweiten elektrischen Kontakt K2 der magnetohydrodynamischen Pumpe 7A verbunden. Die beiden Magnetvorrichtungen 14 der beiden Pumpmodule 10A, 10B umfassen jeweils zwei Permanentmagnete 14A, 14B. Bei einem alternativen nicht dargestellten Ausführungsbeispiel umfasst die mindestens eine Magnetvorrichtung 14 mindestes eine elektrische Spulenvorrichtung. Selbstverständlich können auch mehr als zwei Pumpmodule 10A, 10B in Reihe geschaltet werden. Hierbei erzeugt die Reihenschaltung von Pumpmodulen 10A, 10B einen mit jedem Pumpmodul 10A, 10B größer werdenden Druck in dem elektrisch und thermisch leitfähigen Medium 5, welcher den Volumenstrom des elektrisch und thermisch leitfähigen Mediums 5 durch das geschlossene Kanalsystem 3, 3A, 3B, 3C, 3D antreibt.

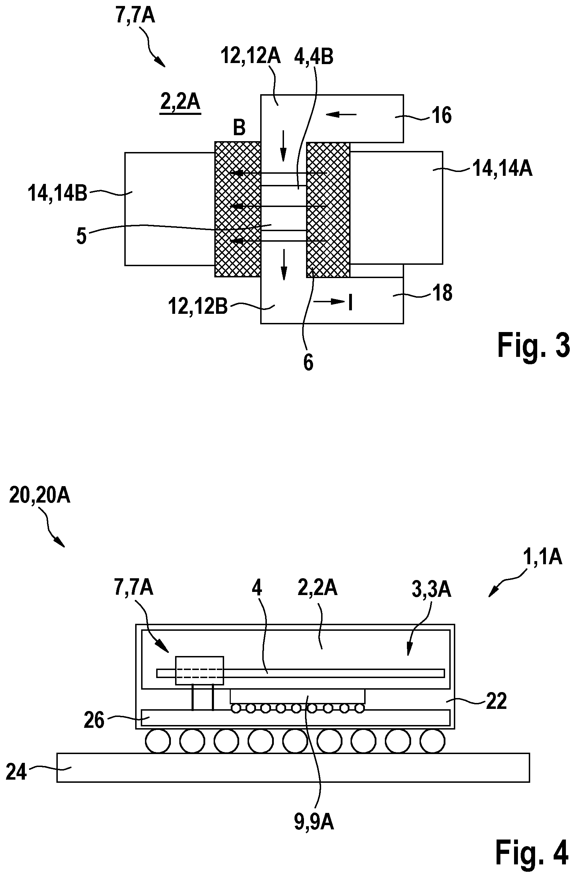

Wie aus Fig. 4 bis 9 weiter ersichtlich ist, umfassen die dargestellten Ausführungsbeispiele des mikroelektrischen Systems 20, 20A, 20B, 20C, 20D jeweils mindestens ein zu temperierendes Objekt 9 und mindestens eine Temperieranordnung 1, 1A, 1B, 1C, 1D zur Temperierung des mindestens einen zu temperierenden Objekts 9. In den dargestellten Ausführungsbeispielen ist jeweils nur ein als Halbleiterchip 9A ausgeführtes zu temperierendes Objekt 9 dargestellt. Selbstverständlich kann das mikroelektrische System 20, 20A, 20B, 20C, 20D auch mehrere und/oder andere zu temperierende Objekte 9, wie beispielsweise elektronische und/oder elektrische Bauteile, Halbleiterbauelemente, Steuergeräte usw. umfassen.

In den dargestellten Ausführungsbeispielen ist das geschlossene Kanalsystem 3, 3A, 3B, 3C, 3D thermisch mit mindestens einem Wärmeübertrager 8 gekoppelt, welcher für den Heizvorgang als Heizelement oder für den Kühlvorgang als Kühlelement 8A ausgeführt ist. Das bedeutet, dass der mindestens eine als Heizelement ausgeführte Wärmeübertrager 8 während eines Heizvorgangs Wärme in das elektrisch und thermisch leitfähige Medium 5 in dem geschlossenes Kanalsystem 3, 3A, 3B, 3C, 3D überträgt, welche von dem elektrisch und thermisch leitfähigen Medium 5 an das mindestens eine zu temperierende Objekt 9 übertragen wird. Während eines Kühlvorgangs nimmt der mindestens eine als Kühlelement 8A ausgeführte Wärmeübertrager 8 Wärme aus dem elektrisch und thermisch leitfähigen Medium 5 auf, welche von dem mindestens einem zu temperierenden Objekt 9 an das elektrisch und thermisch leitfähige Medium 5 übertragen wird. Als elektrisch und thermisch leitfähiges Medium 5 wird in den dargestellten Ausführungsbeispielen jeweils eine ungiftige flüssige Metalllegierung aus Gallium, Indium und Zinn verwendet. Selbstverständlich können auch andere geeignete Fluide als elektrisch und thermisch leitfähiges Medium 5 verwendet werden.

Wie aus Fig. 1 bis 9 weiter ersichtlich ist, ist das geschlossene Kanalsystem 3, 3A, 3B, 3C, 3D zumindest teilweise in einem thermisch leitenden Grundkörper 2, 2A, 2B, 2C, 2D angeordnet, welcher thermisch mit dem mindestens einen zu temperierenden Objekt 9 gekoppelt ist. Hierbei ist der mindestens eine Kanal 4 des geschlossenen Kanalsystems 3, 3A, 3B, 3C, 3D zumindest innerhalb des Grundkörpers 2, 2A, 2B, 2C, 2D von einer elektrischen Isolierung 6 umgeben, so dass der mindestens eine Kanal 4 gegen den Grundkörper 2, 2A, 2B, 2C, 2D elektrisch isoliert ist. Alternativ kann der Grundkörper 2, 2A, 2B, 2C, 2D aus einem thermisch leitfähigen aber elektrisch isolierenden Material, wie beispielsweise Keramik bestehen und die elektrische Isolierung 6 ausbilden. Auch Lösungen mit einem Mischverbund aus elektrisch isolierenden Materialien und Metall sind möglich. Dies kann insbesondere dort erforderlich sein, wenn für eine thermische Schnittstelle zu einem "Hot-Spot" des mindestens einen zu temperierenden Objekts 9 eine hohe Wärmespreizung erforderlich ist. Das bedeutet, dass die elektrische Isolation dann auch über einen Schaltungsträger 24 oder andere Isolationsmechanismen erfolgen kann.

Bei dem in Fig. 1 bis 6 dargestellten ersten Ausführungsbeispiel der Temperieranordnung 1A nimmt der Grundkörper 2A das geschlossene Kanalsystem 3A und die magnetohydrodynamische Pumpe 7 vollständig auf. Hierbei sind die zwei elektrischen Kontakte K1, K2 der magnetohydrodynamischen Pumpe 7A aus dem Grundkörper 2A herausgeführt, um die magnetohydrodynamische Pumpe 7A mit dem Strom I zu versorgen. Die beiden elektrischen Kontakte K1, K2 sind an die vorhandenen Kontaktmittel des korrespondierenden mikroelektrischen Systems 20A, 20B, 20C angepasst, wobei verschiedene geeignete Kontaktierungstechniken zur Kontaktierung eingesetzt werden können. Zudem umfasst das geschlossene Kanalsystem 3A im dargestellten ersten Ausführungsbeispiel der Temperieranordnung 1A nur einen einzigen Kanal 4, welcher mäanderförmig in den Grundkörper 2A eingebettet ist. Selbstverständlich kann die magnetohydrodynamischen Pumpe 7 noch mehr als die dargestellten zwei elektrischen Kontakte K1, K2 aufweisen.

Wie aus Fig. 4 weiter ersichtlich ist, ist der Grundkörper 2A im dargestellten ersten Ausführungsbeispiel des mikroelektrischen Systems 20A thermisch direkt mit einer Oberseite des mindestens einen zu temperierenden Objekts 9 gekoppelt. Zum Ausgleich von Unebenheiten kann bei einem nicht dargestellten Ausführungsbeispiel zwischen dem Grundkörper 2A und der Oberseite des mindestens einem zu temperierenden Objekt 9 ein thermisch leitfähiges Schnittstellenmaterial eingebracht werden. Im dargestellten Ausführungsbeispiel ist das dargestellte als Halbleiterchip 9A ausgeführte zu temperierende Objekt 9 an seiner Unterseite mit einer Platine 26 kontaktiert, welche wiederum mit einem mehrlagigen Schaltungsträger 24 kontaktiert ist. Zudem sind die Temperieranordnung 1A und das mindestens einen zu temperierende Objekt 9 von einer gemeinsamen Umhüllung 22 umgeben. Hierbei kann der Grundkörper 2A wie dargestellt vollständig innerhalb der Umhüllung 22 angeordnet sein oder zumindest an einer Seite seitlich überstehen, um mehr Austauschfläche an die Umgebung zu haben. Selbstverständlich kann der Grundkörper 2A auch an mehreren Seiten über die Umhüllung 22 überstehen.

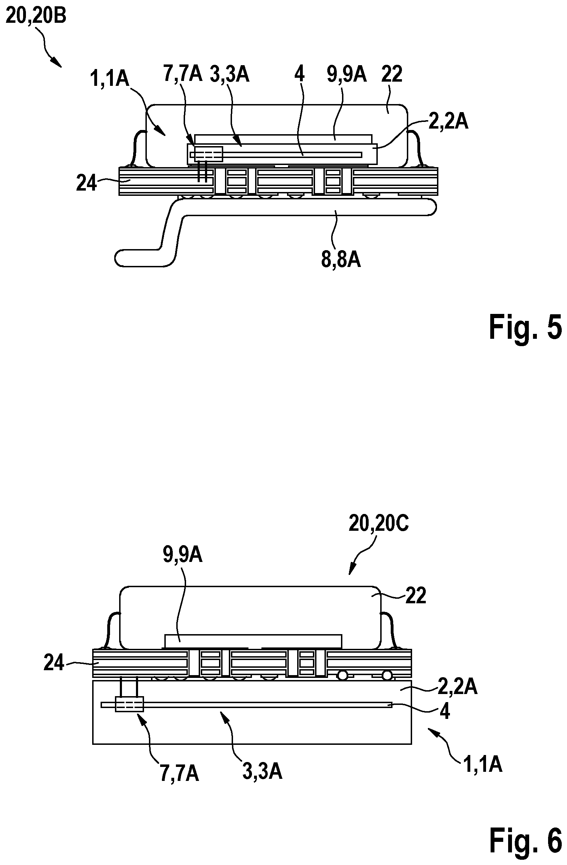

Wie aus Fig. 5 weiter ersichtlich ist, ist der Grundkörper 2A im dargestellten zweiten Ausführungsbeispiel des mikroelektrischen Systems 20B thermisch direkt mit einer Unterseite des mindestens einen zu temperierenden Objekts 9 gekoppelt. Zum Ausgleich von Unebenheiten kann bei einem nicht dargestellten Ausführungsbeispiel zwischen dem Grundkörper 2A und der Unterseite des mindestens einem zu temperierenden Objekt 9 ein thermisch leitfähiges Schnittstellenmaterial eingebracht werden. Im dargestellten Ausführungsbeispiel ist der dargestellte Grundkörper 2A der Temperieranordnung 1A auf einem mehrlagigen Schaltungsträger 24 angeordnet und über thermisch leitfähige Durchkontaktierungen mit einer Oberseite eines als Kühlelement 8A ausgeführten Wärmeübertragers 8 thermisch gekoppelt. Zudem sind die Temperieranordnung 1A und das mindestens einen zu temperierende Objekt 9 von einer gemeinsamen Umhüllung 22 umgeben. Hierbei kann der Grundkörper 2A wie dargestellt vollständig innerhalb der Umhüllung 22 angeordnet sein oder zumindest an einer Seite seitlich überstehen, um mehr Austauschfläche an die Umgebung zu haben. Selbstverständlich kann der Grundkörper 2A auch an mehreren Seiten über die Umhüllung 22 überstehen.

Wie aus Fig. 6 weiter ersichtlich ist, ist der Grundkörper 2A im dargestellten dritten Ausführungsbeispiel des mikroelektrischen Systems 20C an einer Unterseite eines mehrlagigen Schaltungsträgers 24 angeordnet. Das zu temperierende Objekt 9 ist auf einer Oberseite des mehrlagigen Schaltungsträgers 24 angeordnet und von einer Umhüllung 22 umgeben. Der Grundkörper 2A ist thermisch über thermisch leitfähige Durchkontaktierungen mit einer Unterseite des mindestens einen zu temperierenden Objekts 9 gekoppelt.

Bei einem nicht dargestellten Ausführungsbeispiel kann der Grundkörper 2 als Innenlage in einen mehrlagigen Schaltungsträger 24 integriert werden. Hierbei kann die Wärme schnell in die Randlagen geführt und dort beispielsweise in einen Klemmrand eines Gehäuses abgeführt werden, wodurch die zu temperierenden Objekt 9 nicht in der Nähe des Klemmrands angeordnet werden müssen.

Bei einem weiteren nicht dargestellten Ausführungsbeispiel ist der Grundkörper 2 wie eine "Heat Pipe" geformt, wobei gegenüber einer klassischen "Heat Pipe" längere Abstände zwischen einer Wärmequelle und einer Wärmesenke realisiert werden können. Hierbei kann der Grundkörper abschnittsweise von der Materialauswahl so beschaffen sein, dass er flexibel bzw. verformbar ist. Die äußere Form kann beispielsweise rechteckig sein, so dass ebene Flächen der "aktiven" Heat Pipe auf ebenen Entwärmungsflächen des mindestens einen zu temperierenden Objekts 9 thermisch kontaktiert werden können.

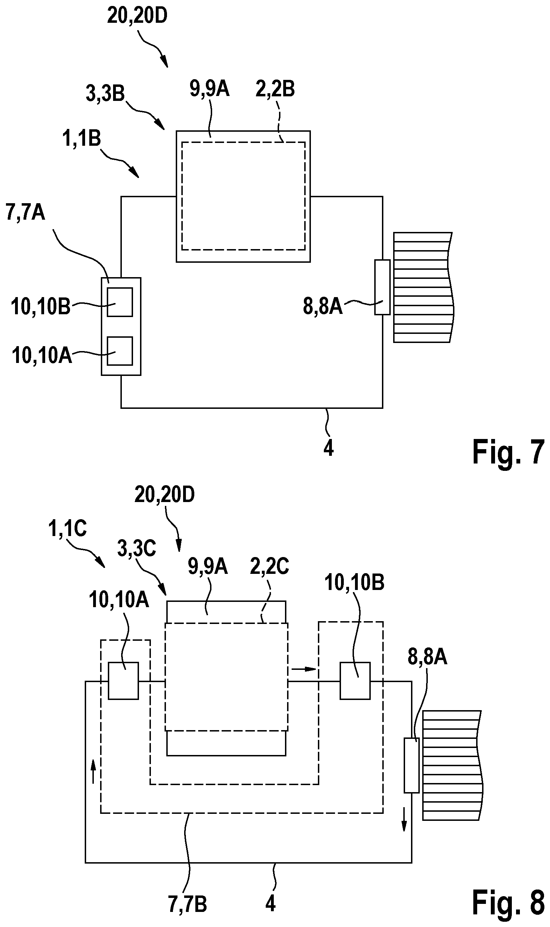

Wie aus Fig. 7 weiter ersichtlich ist, umfasst das dargestellte zweite Ausführungsbeispiel der Temperieranordnung 1B analog zum ersten Ausführungsbeispiel eine magnetohydrodynamische Pumpe 7A mit zwei Pumpmodulen 10A, 10B, welche in einem gemeinsamen Kanal 4 des geschlossenen Kanalsystems 3B fluidisch in Reihe hintereinander angeordnet sind. Wie aus Fig. 7 weiter ersichtlich ist, umfasst die dargestellte Temperieranordnung 1B einen Grundkörper 2B, in welchem nur ein Abschnitt des mindestens einen Kühlkanals 4 angeordnet ist. Der in dem Grundkörper 2B angeordnete Abschnitt des Kühlkanals 4 ist als wesentlich breiterer Hohlraum ausgeführt. Durch diesen Hohlraum im Grundkörper 2B wird das elektrisch und thermisch leitfähige Medium 5 geleitet, um eine flächige Kühlung eines auf dem Grundkörper 2B angeordneten als Halbleiterchip 9A ausgeführten zu temperierenden Objekts 9 zu ermöglichen. Die zwei fluidisch in Reihe angeordneten Pumpmodule 10A, 10B sind hintereinander vor dem zu temperierenden Objekt 9 bzw. dem Grundkörper 2B angeordnet. Zwischen dem zu temperierenden Objekt 9 bzw. dem Grundkörper 2B und der magnetohydrodynamischen Pumpe 7A ist ein als Kühlelement 8A angeordneter Wärmeübertrager 8 angeordnet, welcher von dem elektrisch und thermisch leitfähigen Medium 5 durchströmt wird.

Wie aus Fig. 8 weiter ersichtlich ist, umfasst das dargestellte dritte Ausführungsbeispiel der Temperieranordnung 1C eine magnetohydrodynamische Pumpe 7B mit mindestens zwei fluidisch in Reihe angeordneten Pumpmodulen 10A, 10B, welche getrennt voneinander angeordnet sind. Hierbei ist mindestens ein erstes Pumpmodul 10A vor und mindestens ein zweites Pumpmodul 10B nach dem mindestens einen zu temperierenden Objekt 9 angeordnet. Wie aus Fig. 8 weiter ersichtlich ist, umfasst die dargestellte Temperieranordnung 1C einen Grundkörper 2C, in welchem nur ein Abschnitt des mindestens einen Kühlkanals 4 angeordnet ist. Der in dem Grundkörper 2C angeordnete Abschnitt des Kühlkanals 4 ist als wesentlich breiterer Hohlraum ausgeführt, in welchem senkrecht zur Strömungsrichtung des elektrisch und thermisch leitfähigen Mediums 5 zusätzliche Pins eingebracht sind. Durch diesen Hohlraum im Grundkörper 2C wird das elektrisch und thermisch leitfähige Medium 5 geleitet, um eine flächige Kühlung eines auf dem Grundkörper 2C angeordneten als Halbleiterchip 9A ausgeführten zu temperierenden Objekts 9 zu ermöglichen. Die zusätzlichen Pins im Hohlraum verbessern die flächige Verteilung des elektrisch und thermisch leitfähigen Mediums 5 in dem Hohlraum. Zwischen dem mindestens einen zweiten Pumpmodul 10B und dem mindestens einen ersten Pumpmodul 10A ist ein als Kühlelement 8A angeordneter Wärmeübertrager 8 angeordnet, welcher von dem elektrisch und thermisch leitfähigen Medium 5 durchströmt wird.

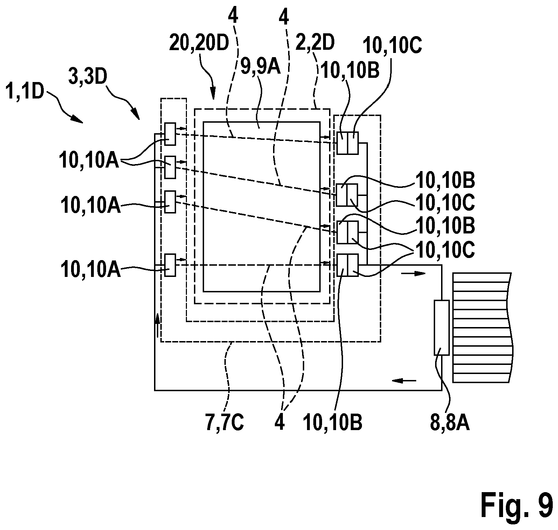

Wie aus Fig. 9 weiter ersichtlich ist, umfasst das dargestellte vierte Ausführungsbeispiel der Temperieranordnung 1D ein Kanalsystem 3D mit mehreren fluidisch parallel angeordneten Kanälen 4 mit einem gemeinsamen Zulauf und einem gemeinsamen Ablauf sowie eine magnetohydrodynamische Pumpe 7C mit mindestens zwei Pumpmodulen 10A, 10B, welche fluidisch parallel in mindestens zwei parallel verlaufenden Kanälen 4 angeordnet sind. Im dargestellten Ausführungsbeispiel sind vier parallel verlaufende Kanäle 4 in einem gemeinsamen Grundkörper 2D angeordnet. Wie aus Fig. 9 weiter ersichtlich ist, sind in jedem der fluidisch parallel angeordneten Kanälen 4 mindestens zwei fluidisch in Reihe angeordneten Pumpmodule 10A, 10B getrennt voneinander angeordnet. Hierbei ist in den einzelnen Kanäle 4 mindestens ein erstes Pumpmodul 10A vor und mindestens ein zweites Pumpmodul 10B nach dem mindestens einen zu temperierenden Objekt 9 angeordnet. Wie aus Fig. 9 weiter ersichtlich ist, umfasst die dargestellte Temperieranordnung 1D in jedem der vier parallel verlaufenden Kanäle ein zusätzliches als Sensormodul 10C ausgeführtes magnetohydrodynamisches Modul 10. Bei einem solchen Sensormodul 10C greifen die Elektroden 12A, 12B der Elektrodenvorrichtung 12 an dem mindestens einen Kanalabschnitt 4A, 4B eine durch den Volumenstrom des elektrisch und thermisch leitfähigen Mediums 5 in Zusammenwirkung mit dem erzeugten magnetischen Feld B der Magnetvorrichtung 14 resultierende Induktionsspannung ab, aus welcher eine Strömungsgeschwindigkeit des elektrisch und thermisch leitfähigen Mediums 5 ermittelbar ist. Zudem umfasst das Sensormodul einen nicht näher dargestellten Temperatursensor, um die Temperatur des elektrisch und thermisch leitfähigen Mediums 5 in dem korrespondierenden Kanal 4 zu ermitteln. Die dargestellte Temperieranordnung 1D ermöglicht durch die fluidische Parallelschaltung der mindestens zwei Pumpmodule 10A, 10B in Verbindung mit der oben beschriebenen Temperaturmessung die Realisierung einer individuellen Volumenströmung in den einzelnen parallel verlaufenden Kanälen 4, um beispielsweise Hotspots auf dem zu temperierenden Objekt 9 zu vermeiden bzw. ganz gezielt verlustreiche Bereiche des zu temperierenden Objekts 9 zu kühlen oder für eine gleichmäßige Temperatur oder eine gezielte Temperaturverteilung zu sorgen. Zwischen dem gemeinsamen Ablauf und dem gemeinsamen Zulauf der fluidisch parallel verlaufenden Kanäle 4 ist ein als Kühlelement 8A angeordneter Wärmeübertrager 8 angeordnet, welcher von dem elektrisch und thermisch leitfähigen Medium 5 durchströmt wird. Bei dem dargestellten vierten Ausführungsbeispiel der Temperieranordnung 1D können mehrere erste Pumpmodule 10A vor dem zu temperierenden Objekt 9 und mehrere zweite Pumpmodule 10B nach dem zu temperierenden Objekt 9 angeordnet sein.

Bei einem weiteren nicht dargestellten Ausführungsbeispiel der Temperieranordnung 1 sind die nach dem zu temperierenden Objekt 9 angeordneten magnetohydrodynamischen Module 10 umschaltbar ausgeführt. Die umschaltbaren magnetohydrodynamischen Module 10 werden in einer ersten Betriebsart als zweites Pumpmodul 10B und in einer zweiten Betriebsart als Sensormodul 10C betrieben.

Ausführungsformen der erfindungsgemäßen Temperieranordnung können beliebig skaliert werden. Das bedeutet, dass Strukturgrößen kleiner als 1 mm möglich sind. Dies betrifft insbesondere die Dicke des Grundkörpers und auch die Kanaldurchmesser, welche auch nur wenig µm sein können. Der Größe der Temperieranordnung sind auch keine technischen Grenzen gesetzt. Dies betrifft insbesondere eine zu temperierende Fläche, welche mit Ausführungsformen der erfindungsgemäßen Temperieranordnung angebunden werden kann. Aufgrund der sehr guten Skalierbarkeit kann durch Ausführungsformen der erfindungsgemäßen Temperieranordnung Wärmenergie in Höhe von wenigen Milliwatt bis hin zu Megawatt abgeführt werden. Mit Ausführungsformen der erfindungsgemäßen Temperieranordnung ist es möglich, zu temperierende Objekte bis leicht unter der Siedetemperatur des verwendeten elektrisch und thermisch leitfähigen Mediums zu kühlen. Bei der Verwendung der flüssigen Metalllegierung aus Gallium, Indium und Zinn beträgt die Siedetemperator 1300°C. Dies ist deutlich mehr als die zulässige Temperatur von reinem Wasser, Wasser-Glykol-Mischungen oder typischen Kühlmedien in bekannten Klimaanlagenkompressoren.

## Patentansprüche

1. Temperieranordnung (1) für ein mikroelektrisches System (20), mit einem geschlossenem Kanalsystem (3), welches mindestens einen Kanal (4) zur Führung eines elektrisch und thermisch leitfähigen Mediums (5) umfasst und thermisch mit mindestens einem zu temperierenden Objekt (9) des mikroelektrischen Systems (20) koppelbar ist, und einer magnetohydrodynamischen Pumpe (7) mit mehreren magnetohydrodynamischen Modulen (10), welche jeweils eine Elektrodenvorrichtung (12) mit zwei Elektroden (12A, 12B) und eine Magnetvorrichtung (14) aufweisen, welche ein magnetisches Feld (B) erzeugt, wobei mindestens zwei magnetohydrodynamische Module (10) als Pumpmodule (10A, 10B) ausgeführt und elektrisch in Reihe geschaltet sind und in einem gemeinsamen Kanal (4) fluidisch in Reihe getrennt voneinander angeordnet sind, wobei mindestens ein erstes Pumpmodul (10A) vor und mindestens ein zweites Pumpmodul (10B) nach dem mindestens einen zu temperierenden Objekt (9) angeordnet ist, wobei in den Pumpmodulen (10A, 10B) jeweils eine erste Elektrode (12A) der Elektrodenvorrichtung (12) einen elektrischen Stromfluss (I) mit einer vorgegebenen Stromdichte (j) an mindestens einem Kanalabschnitt (4A, 4B) in das elektrisch und thermisch leitfähige Medium (5) einleitet und eine zweite Elektrode (12B) der Elektrodenvorrichtung (12) den elektrischen Stromfluss (I) an dem mindestens einen Kanalabschnitt (4A, 4B) aus dem elektrisch und thermisch leitfähigen Medium (5) ausleitet, so dass ein Zusammenwirken des in dem geschlossenen Kanalsystem (3) geführten elektrisch und thermisch leitfähigen Mediums (5) mit dem eingeleiteten elektrischen Stromfluss (I) und mit dem erzeugten magnetischen Feld (B) eine Lorenzkraft (FL) erzeugt, welche das elektrisch und thermisch leitfähige Medium (5) in dem mindestens einen Kanalabschnitt (4A, 4B) gezielt beschleunigt, und ein resultierender Druckaufbau einen gewünschten Volumenstrom des elektrisch und thermisch leitfähigen Mediums (5) durch den mindestens einen Kanal (4) des geschlossenen Kanalsystems (3) bewirkt, wobei der Volumenstrom des elektrisch und thermisch leitfähigen Mediums (5) eine Temperierung des mindestens einen zu temperierenden Objekts (9) bewirkt, wobei das elektrisch und thermisch leitfähige Medium (5) geeignet ist, während eines Heizvorgangs Wärme an das mindestens eine zu temperierende Objekt (9) zu übertragen oder während eines Kühlvorgangs Wärme von dem mindestens einen zu temperierenden Objekt (9) aufzunehmen.

2. Temperieranordnung (1) nach Anspruch 1, **dadurch gekennzeichnet, dass** das geschlossene Kanalsystem (3) thermisch mit mindestens einem Wärmeübertrager (8) gekoppelt ist, welcher für den Heizvorgang als Heizelement oder für den Kühlvorgang als Kühlelement (8A) ausgeführt ist.

3. Temperieranordnung (1) nach Anspruch 1 oder 2, **dadurch gekennzeichnet, dass** das geschlossene Kanalsystem (3) zumindest teilweise in einem thermisch leitenden Grundkörper (2) angeordnet ist, welcher Teil der Temperieranordnung (1) ist und thermisch mit dem mindestens einen zu temperierenden Objekt (9) koppelbar ist.

4. Temperieranordnung (1) nach Anspruch 3, **dadurch gekennzeichnet, dass** der Grundkörper (2) das geschlossene Kanalsystem (3) und die magnetohydrodynamische Pumpe (7) vollständig aufnimmt.

5. Temperieranordnung (1) nach Anspruch 3 oder 4, **dadurch gekennzeichnet, dass** der Grundkörper (2) direkt oder über ein thermisch leitfähiges Schnittstellenmaterial mit einer Oberseite oder einer Unterseite des mindestens einen zu temperierenden Objekts (9) thermisch koppelbar ist.

6. Temperieranordnung (1) nach Anspruch 3 oder 4, **dadurch gekennzeichnet, dass** der Grundkörper (2) über mindestens eine thermisch leitfähige Durchkontaktierung mit einer Oberseite oder einer Unterseite des mindestens einen zu temperierenden Objekts (9) thermisch koppelbar ist.

7. Temperieranordnung (1) nach einem der Ansprüche 3 bis 6, **dadurch gekennzeichnet, dass** der mindestens eine Kanal (4) zumindest innerhalb des Grundkörpers (2) von einer elektrischen Isolierung (6) umgeben ist.

8. Temperieranordnung (1) nach einem der Ansprüche 1 bis 7, **dadurch gekennzeichnet, dass** mindestens ein magnetohydrodynamisches Modul (10) als Sensormodul (10C) ausgeführt ist, bei welchem die Elektroden (12A, 12B) der Elektrodenvorrichtung (12) an dem mindestens einen Kanalabschnitt (4A, 4B) eine durch den Volumenstrom des elektrisch und thermisch leitfähigen Mediums (5) in Zusammenwirkung mit dem erzeugten magnetischen Feld (B) der Magnetvorrichtung (14) resultierende Induktionsspannung abgreifen, aus welcher eine Strömungsgeschwindigkeit des elektrisch und thermisch leitfähigen Mediums (5) ermittelbar ist.

9. Temperieranordnung (1) nach einem der Ansprüche 1 bis 8, **dadurch gekennzeichnet, dass** mindestens ein magnetohydrodynamisches Modul (10) umschaltbar ausgeführt ist und in einer ersten Betriebsart als Pumpmodul (10A, 10B) und in einer zweiten Betriebsart als Sensormodul (10C) betreibbar ist.

10. Temperieranordnung (1) nach einem der Ansprüche 1 bis 9, **dadurch gekennzeichnet, dass** die mindestens zwei Pumpmodule (10A, 10B) fluidisch parallel in mindestens zwei parallel verlaufenden Kanälen (4) angeordnet sind, wobei in mindestens einem der mindestens zwei parallel verlaufenden Kanäle (4) mindestens zwei fluidisch in Reihe hintereinander angeordnete magnetohydrodynamische Module (10) angeordnet sind.

11. Temperieranordnung (1) nach einem der Ansprüche 1 bis 10, **dadurch gekennzeichnet, dass** die mindestens eine Magnetvorrichtung (14) mindestens zwei Permanentmagnete (14A, 14B) oder mindestes eine elektrische Spulenvorrichtung umfasst.

12. Mikroelektrisches System (20) mit mindestens einem zu temperierenden Objekt (9) und mindestens einer Temperieranordnung (1), welche zur Temperierung des mindestens einen zu temperierenden Objekts (9) nach einem Ansprüche 1 bis 11 ausgeführt ist.

13. Mikroelektrisches System (20) nach Anspruch 12, **dadurch gekennzeichnet, dass** die mindestens eine Temperieranordnung (1) und das mindestens eine zu temperierende Objekt (9) von einer gemeinsamen Umhüllung (22) umgeben sind.

## Claims

1. Temperature-control assembly (1) for a microelectric system (20), with a closed channel system (3), which comprises at least one channel (4) for guiding an electrically and thermally conductive medium (5) and can be thermally coupled to at least one object (9) to be temperature-controlled of the microelectric system (20), and a magneto hydrodynamic pump (7) with a plurality of magnetohydrodynamic modules (10), which each have an electrode device (12) with two electrodes (12A, 12B) and a magnet device (14) which generates a magnetic field (B), wherein at least two magnetohydrodynamic modules (10) are designed as pump modules (10A, 10B) and are electrically connected in series and arranged fluidically separate from one another in series in a common channel (4), wherein at least one first pump module (10A) is arranged upstream and at least one second pump module (10B) is arranged downstream of the at least one object (9) to be temperature-controlled, wherein in each of the pump modules (10A, 10B) a first electrode (12A) of the electrode device (12) conducts an electric current flow (I) with a predefined current density (j) into the electrically and thermally conductive medium (5) at at least one channel portion (4A, 4B) and a second electrode (12B) of the electrode device (12) conducts the electric current flow (I) out of the electrically and thermally conductive medium (5) at the at least one channel portion (4A, 4B), so that an interaction of the electrically and thermally conductive medium (5) guided in the closed channel system (3) with the conducted-in electric current flow (I) and with the generated magnetic field (B) produces a Lorentz force (FL), which specifically accelerates the electrically and thermally conductive medium (5) in the at least one channel portion (4A, 4B), and a resultant pressure build-up causes a desired volume flow of the electrically and thermally conductive medium (5) through the at least one channel (4) of the closed channel system (3), wherein the volume flow of the electrically and thermally conductive medium (5) has the effect of controlling the temperature of the at least one object (9) to be temperature-controlled, wherein the electrically and thermally conductive medium (5) is suitable for transferring heat to the at least one object (9) to be temperature-controlled during a heating process or absorbing heat from the at least one object (9) to be temperature-controlled during a cooling process.

2. Temperature-control assembly (1) according to Claim 1, **characterized in that** the closed channel system (3) is thermally coupled to at least one heat exchanger (8), which is designed as a heating element for the heating process or as a cooling element (8A) for the cooling process.

3. Temperature-control assembly (1) according to Claim 1 or 2, **characterized in that** the closed channel system (3) is at least partially arranged in a thermally conducting main body (2), which is part of the temperature-control assembly (1) and can be thermally coupled to the at least one object (9) to be temperature-controlled.

4. Temperature-control assembly (1) according to Claim 3, **characterized in that** the main body (2) completely accommodates the closed channel system (3) and the magnetohydrodynamic pump (7).

5. Temperature-control assembly (1) according to Claim 3 or 4, **characterized in that** the main body (2) can be thermally coupled directly or by way of a thermally conductive interface material to an upper side or an underside of the at least one object (9) to be temperature-controlled.

6. Temperature-control assembly (1) according to Claim 3 or 4, **characterized in that** the main body (2) can be thermally coupled by way of at least one thermally conductive via to an upper side or an underside of the at least one object (9) to be temperature-controlled.

7. Temperature-control assembly (1) according to one of Claims 3 to 6, **characterized in that** the at least one channel (4) is surrounded at least within the main body (2) by an electrical insulation (6).

8. Temperature-control assembly (1) according to one of Claims 1 to 7, **characterized in that** at least one magnetohydrodynamic module (10) is designed as a sensor module (10C) for which the electrodes (12A, 12B) of the electrode device (12) tap at the at least one channel portion (4A, 4B) an induction voltage which results from the volume flow of the electrically and thermally conductive medium (5) in interaction with the generated magnetic field (B) of the magnet device (14) and from which a flow velocity of the electrically and thermally conductive medium (5) can be ascertained.

9. Temperature-control assembly (1) according to one of Claims 1 to 8, **characterized in that** at least one magnetohydrodynamic module (10) is designed to be switchable and can be operated in a first operating mode as a pump module (10A, 10B) and in a second operating mode as a sensor module (10C).

10. Temperature-control assembly (1) according to one of Claims 1 to 9, **characterized in that** the at least two pump modules (10A, 10B) are arranged fluidically in parallel in at least two parallel-running channels (4), wherein at least two magnetohydrodynamic modules (10) arranged fluidically in series one behind the other are arranged in at least one of the at least two parallel-running channels (4).

11. Temperature-control assembly (1) according to one of Claims 1 to 10, **characterized in that** the at least one magnet device (14) comprises at least two permanent magnets (14A, 14B) or at least one electrical coil device.

12. Microelectric system (20) with at least one object (9) to be temperature-controlled and at least one temperature-control assembly (1), which is designed for controlling the temperature of the at least one object (9) to be temperature-controlled according to one of Claims 1 to 11.

13. Microelectric system (20) according to Claim 12, **characterized in that** the at least one temperature-control assembly (1) and the at least one object (9) to be temperature-controlled are surrounded by a common casing (22).

## Revendications

1. Ensemble de régulation de température (1) pour un système microélectrique (20), comportant un système de canaux fermés (3) qui comprend au moins un canal (4) pour guider un milieu électriquement et thermiquement conducteur (5) et qui peut être couplé thermiquement à au moins un objet à réguler thermiquement (9) du système microélectrique (20), et une pompe magnétohydrodynamique (7) comportant plusieurs modules magnétohydrodynamiques (10), qui comportent respectivement un dispositif à électrodes (12) ayant deux électrodes (12A, 12B) et un dispositif à aimant (14) générant un champ magnétique (B), au moins deux modules magnétohydrodynamiques (10) étant conçus sous forme de modules de pompe (10A, 10B) et étant électriquement connectés en série, et étant disposés en série de manière fluidiquement séparée les uns des autres dans un canal commun (4), au moins un premier module de pompe (10A) étant disposé en amont et au moins un second module de pompe (10B) étant disposé en aval dudit au moins un objet à réguler thermiquement (9), étant entendu que, dans les modules de pompe (10A, 10B), une première électrode (12A) du dispositif à électrodes (12) introduit un flux de courant (I) ayant une densité de courant prédéfinie (j) au niveau d'au moins une partie de canal (4A, 4B) dans le milieu électriquement et thermiquement conducteur (5) et une seconde électrode (12B) du dispositif à électrodes (12) conduit le flux de courant (I) hors du milieu électriquement et thermiquement conducteur (5) au niveau de ladite au moins une partie de canal (4A, 4B) de telle sorte qu'une interaction du milieu électriquement et thermiquement conducteur (5) guidé dans le système de canaux fermés (3) avec le flux de courant introduit (I) et avec le champ magnétique généré (B) génère une force de Lorenz (FL), laquelle accélère de manière ciblée le milieu électriquement et thermiquement conducteur (5) dans ladite au moins une partie de canal (4A, 4B), ce qui entraîne une augmentation de pression qui provoque un débit volumique souhaité du milieu électriquement et thermiquement conducteur (5) à travers ledit au moins un canal (4) du système de canaux fermés (3), le débit volumique du milieu électriquement et thermiquement conducteur (5) provoquant une régulation thermique dudit au moins un objet à réguler thermiquement (9), le milieu électriquement et thermiquement conducteur (5) étant approprié pour transférer de la chaleur audit au moins un objet à réguler thermiquement (9) pendant un processus de chauffage ou pour absorber la chaleur dudit au moins un objet à réguler thermiquement (9) pendant un processus de refroidissement.

2. Ensemble de régulation de température (1) selon la revendication 1, **caractérisé en ce que** le système de canaux fermés (3) est couplé thermiquement à au moins un échangeur de chaleur (8) qui est conçu sous forme d'élément chauffant pour le processus de chauffage ou sous forme d'élément réfrigérant (8A) pour le processus de refroidissement.

3. Ensemble de régulation de température (1) selon la revendication 1 ou 2, **caractérisé en ce que** le système de canaux fermés (3) est disposé au moins en partie dans un corps de base (2) thermiquement conducteur, qui fait partie de l'ensemble de régulation thermique (1) et peut être couplé thermiquement audit au moins un objet à réguler thermiquement (9).

4. Ensemble de régulation de température (1) selon la revendication 3, **caractérisé en ce que** le corps de base (2) reçoit entièrement le système de canaux fermés (3) et la pompe magnétohydrodynamique (7).

5. Ensemble de régulation de température (1) selon la revendication 3 ou 4, **caractérisé en ce que** le corps de base (2) peut être couplé thermiquement, directement ou par l'intermédiaire d'un matériau d'interface thermiquement conducteur, à une face supérieure ou à une face inférieure dudit au moins un objet à réguler thermiquement (9).

6. Ensemble de régulation de température (1) selon la revendication 3 ou 4, **caractérisé en ce que** le corps de base (2) peut être couplé thermiquement, par l'intermédiaire d'au moins un contact traversant thermiquement conducteur, à une face supérieure ou à une face inférieure dudit au moins un objet à réguler thermiquement (9).

7. Ensemble de régulation de température (1) selon l'une des revendications 3 à 6, **caractérisé en ce que** ledit au moins un canal (4) est entouré d'une isolation électrique (6) au moins à l'intérieur du corps de base (2).

8. Ensemble de régulation de température (1) selon l'une des revendications 1 à 7, **caractérisé en ce qu'**au moins un module magnétohydrodynamique (10) est conçu sous la forme d'un module de capteur (10C) dans lequel les électrodes (12A, 12B) du dispositif à électrodes (12) prélèvent une tension d'induction résultant du débit volumique du milieu électriquement et thermiquement conducteur (5) au niveau de ladite au moins une partie de canal (4A, 4B), en interaction avec le champ magnétique (B) généré par le dispositif à aimant (14), laquelle tension d'induction permet de déterminer une vitesse d'écoulement du milieu électriquement et thermiquement conducteur (5).

9. Ensemble de régulation de température (1) selon l'une des revendications 1 à 8, **caractérisé en ce qu'**au moins un module magnétohydrodynamique (10) est réalisé de manière commutable et peut fonctionner dans un premier mode comme module de pompe (10A, 10B) et dans un second mode comme module de capteur (10C).

10. Ensemble de régulation de température (1) selon l'une des revendications 1 à 9, **caractérisé en ce que** lesdits au moins deux modules de pompe (10A, 10B) sont disposés fluidiquement en parallèle dans au moins l'un desdits au moins deux canaux s'étendant parallèlement (4), au moins deux modules magnétohydrodynamiques (10) disposés fluidiquement en série l'un après l'autre étant disposés dans au moins l'un desdits au moins deux canaux s'étendant parallèlement (4).

11. Ensemble de régulation de température (1) selon l'une des revendications 1 à 10, **caractérisé en ce que** ledit au moins un dispositif à aimant (14) comprend au moins deux aimants permanents (14A, 14B) ou au moins un dispositif à bobine électrique.

12. Système microélectrique (20) comprenant au moins un objet à réguler thermiquement (9) et au moins un ensemble de régulation de température (1) qui est conçu pour réguler thermiquement au moins un objet à réguler thermiquement (9) selon l'une des revendications 1 à 11.

13. Système microélectrique (20) selon la revendication 12, **caractérisé en ce que** ledit au moins un ensemble de régulation de température (1) et ledit au moins un objet à réguler thermiquement (9) sont entourés d'une enveloppe commune (22).
